# EUROPEAN PATENT SPECIFICATION

(11) **EP 3 454 120 B1**
(45) Date of publication and mention of the grant of the patent: **01.05.2024**
(21) Application number: 17190264.6
(22) Date of filing: 09.09.2017
(51) Int. Cl.: G03F 1/22, G03F 1/54, G03F 1/24, G03F 1/48, G03F 1/52, G21K 1/06

(54) **METHOD FOR MANUFACTURING EUV RETICLES AND RETICLES FOR EUV LITHOGRAPHY**
VERFAHREN ZUR HERSTELLING VON EUV RETIKELN UND RETIKEL FÜR EUV-LITHOGRAPHIE
MÉTHODE POUR LA FABRICATION DE RÉTICULES EUV ET RÉTICULES POUR LITHOGRAPHIE EUV

(43) Date of publication of application: 13.03.2019
(73) Proprietor: IMEC VZW, 3001 Leuven (BE); Katholieke Universiteit Leuven, 3000 Leuven (BE)
(72) Inventor: CHAN, Boon Teik, 3001 Leuven (BE); LUONG, Kim Vu, 3001 Leuven (BE); PHILIPSEN, Vicky, 3001 Leuven (BE); ALTAMIRANO SANCHEZ, Efrain, 3001 Leuven (BE); VANDERSMISSEN, Kevin, 3001 Leuven (BE)
(74) Representative: Winger

(56) References cited:
- EP-A2- 1 333 323
- EP-A2- 1 412 817
- EP-B1- 1 412 817
- US-A1- 2003 194 850
- US-A1- 2004 091 789
- US-A1- 2005 106 474
- US-A1- 2012 045 712
- US-A1- 2013 280 643
- US-A1- 2015 331 307
- PHILIPSEN VICKY ET AL: "Reducing EUV mask 3D effects by alternative metal absorbers", PROCEEDINGS OPTICAL DIAGNOSTICS OF LIVING CELLS II, SPIE, US, vol. 10143, 24 March 2017 (2017-03-24), pages 1014310-1014310, XP060088031, ISSN: 0277-786X, DOI: 10.1117/12.2257929 ISBN: 978-1-5106-1324-9

## Description

### Technical Field

The present invention is related to the field of lithography. More specifically, it is related to fabrication of reticles for Extreme Ultra-Violet Lithography (EUVL).

### Background

Continuous reduction of feature sizes, based on Moore's Law, in IC manufacturing necessitates the transition to EUVL to pattern features having a critical dimension (CD) value of sub-10 nm. EUVL uses 13.5 nm light to enable single exposure patterning down to below 10 nm, therefore making it possible to keep up with Moore's Law.

The absorber material present above the multi-layer mirror in the reticles used for EUVL plays an important role in terms of absorption of EUV light during lithography. Therefore, it is desirable that the absorber material possesses a high extinction coefficient, k, value. Currently, Ta-based absorber material is used in EUV reticles having a typical thickness of 70 nm. However, these traditional EUV masks suffer from Mask 3D (M3D) effects such as shadowing differences between horizontal and vertical patterns, best focus shifts through pitch, and pattern shifts through focus. M3D effects result from the interaction between the oblique incident EUV light and the patterned absorber material with typical thickness values in the order of several wavelengths. M3D effects can make it difficult to perform optical proximity correction, and lead to overlay problems. It has been shown that reducing the thickness of the current Ta-based absorber materials is not fully sufficient to mitigate M3D effects (Ref: *"*Reducing EUV mask 3D effects by alternative metal absorbers", Conference Proceedings of SPIE 2017).

Furthermore, in addition to the absorber material having suitable material properties making it compatible for use in reticles in an EUV scanner environment and making it environmentally friendly, it should also be compatible with the current EUV reticle fabrication processes. This compatibility should ideally ensure obtaining absorber profiles as square as possible, the absence of mask defects on the mask, and the absence of damage on the capping layer protecting the multi-layer mirror or on the multi-layer mirror itself, during reticle fabrication. The absorber material is typically provided by blanket layer deposition methods or by non-selective deposition methods on the multi-layer mirror, which necessitates further the use of etch-back or chemical mechanical planarization (CMP) techniques to arrive at the desired absorber patterns. However, these techniques make the manufacturing cost of reticles not only expensive due to the introduction of these further steps, but also etch-back or CMP techniques can damage the Ru capping and/or the multi-layer mirror, which is undesirable.

There is, therefore, a need in the art for methods for fabricating EUV reticles, which resolve some or all of the issues outlined above.

EP1412817 discloses a method for making an extreme ultraviolet reticle, comprising providing an assembly comprising an extreme ultraviolet mirror; and a trench overlaying at least a bottom part of the extreme ultraviolet mirror; and filling the trench with a metal layer.

US2004091789 discloses an EUV mask includes an opening that helps to attenuate and phase shift extreme ultraviolet radiation using a subtractive rather than additive method.

US2013280643 discloses a method for forming a reflective mask. In the method, various layers, such as the conductive layer, the reflective multilayer, the first and second absorption layers, and the production layer, may be deposited by a plating process such as electrode-less plating or electroplating. The second absorption layer may be nickel.

### Summary of the invention

It is an object of the present invention to provide good methods for forming EUV reticles.

It is an advantage of embodiments of the present invention that the EUV absorbing structures may have sidewalls that are straight, i.e. substantially free from angles and not curved when the surface roughness is neglected.

It is an advantage of embodiments of the present invention that the EUV absorbing structures have sidewalls that may be vertical or close to being vertical.

It is an advantage of embodiments of the present invention that the formation of the EUV absorbing structures lead to no or negligible defects on the mask, which means that during patterning no or a few damages are created on the EUV mirror or its capping layer and therefore its reflective properties are not altered where no EUV absorbing structure is intended. In the comparative subtractive method, EUV absorbing material removed by physical etching from the mother layer, such as a Ni or Co mother layer, tend to deposit on the EUV mirror outside of where the EUV absorbing material is wished.

It is an advantage of embodiments of the present invention that the EUV absorbing structures may have no voids therein.

It is an advantage of embodiments of the present invention that the EUV absorbing structures may comprise amorphous or polycrystalline material having an average crystallite size of 10 nm or smaller. This translates into an EUV absorbing structure having relatively smooth side walls.

It is an advantage of embodiments of the present invention that no or few damages to the capping layer is caused. This capping layer is preferably left undamaged in order to keep its protective properties for the EUV mirror underneath.

It is an advantage of embodiments of the present invention that the EUV absorbing structures formed above the EUV mirror are with low or no internal stress so that no bending of the reticle patterns occurs.

It is an advantage of embodiments of the present invention that the EUV absorbing structures may be stable in the temperature range 20-250°C, preferably 20-180°C.

It is an advantage of embodiments of the present invention that it permits the use of a width as small as or even smaller than 64 nm for the EUV absorbing structure, which translates into features as small as or even smaller than 16 nm on the wafer at a numerical aperture (NA) of 0.33. Embodiments of the present invention can even permit the use of a width much smaller than 64 nm for the EUV absorbing structure such as for instance a width of 24 nm, which translates into features as small as 6 nm on the wafer a numerical aperture (NA) of 0.33.

It is an advantage of embodiments of the present invention that manufacturing cost of EUV reticles can be reduced when compared to subtractive or non-selective methods.

The above objective is accomplished by a method according to the present invention.

In a first aspect, the present invention is as indicated in claim 1.
Not forming part of the invention, but considered useful for understanding the invention resulting from
the claimed method, herein is also described an extreme ultraviolet reticle, comprising:
- an extreme ultraviolet mirror (2); and
- an extreme ultraviolet absorbing structure comprising a metallic material comprising an element selected from Ni, Co, Sb, Ag, In and Sn.

Not forming part of the invention, but considered useful for understanding the invention resulting from the claimed method, herein is also described an intermediate structure in the making of an extreme ultraviolet reticle, the intermediate structure comprising
- an extreme ultraviolet mirror;
- a mask layer over the extreme ultraviolet mirror, the mask layer being patterned with a cavity extending from a top surface to a bottom surface of the mask layer; and
- an extreme ultraviolet absorbing structure filling at least partly the cavity, the extreme ultraviolet absorbing structure comprising a metallic material comprising an element selected from Ni, Co, Sb, Ag, In and Sn.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Figs. 1 to 4 are schematic representations of vertical cross-sections of intermediates in the formation of a reticle during a method according to an embodiment of the present invention.
Figs. 5 to 8 are schematic representations of vertical cross-sections of intermediates in the formation of a reticle during a method according to another embodiment of the present invention.
Figs. 9 to 14 are schematic representations of vertical cross-sections of intermediates in the formation of a reticle during a method according to yet another embodiment of the present invention.
Figs. 15 to 18 are schematic representations of vertical cross-sections of intermediates in the formation of a reticle during a method according to yet another embodiment of the present invention.
Figs. 19 to 20 are schematic representations of vertical cross-sections of intermediates in the formation of a reticle during a method according to yet another embodiment of the present invention.
Fig. 21 is an electron micrograph showing a vertical cross-section of an assembly without EUV mirror, obtained as a proof of concept for the present invention.
Fig. 22 is an electron micrograph showing a vertical cross-section of another assembly without EUV mirror, obtained as a proof of concept for the present invention.
Fig. 23 is an electron micrograph showing a vertical cross-section of yet another assembly without EUV mirror, obtained as a proof of concept for the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

As used herein, and unless otherwise specified, under extreme ultraviolet (EUV) may be understood that part of the electromagnetic spectrum spanning wavelengths from 124 nm down to 10 nm.

As used herein, and unless otherwise specified, the refractive index (n) and extinction coefficient (κ) are respectively the real and imaginary parts of the complex index of refraction (n = n - iκ). Unless otherwise specified, their values herein are those measured at a wavelength of 13.5 nm. 13.5 nm is the most commonly used wavelength for extreme ultraviolet lithography today, though the invention is in no way limited to this specific wavelength. Both the refractive index and the extinction coefficient can for example be obtained from angle resolved reflectance measurements; and more preferably from angle-and-wavelength resolved reflectance measurements (thereby increasing the redundancy available to fit both n an κ). Other possibilities available to the skilled person include, but are not limited to, transmittance and/or absorbance measurements.

As used herein, and unless otherwise specified, the average crystallite size of an alloy is the average size of crystals within the alloy. It may also be referred to as the grain size.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

In a first aspect, the present invention relates to a method for making an extreme ultraviolet reticle as described in claim 1. The method comprises a step a of providing an assembly comprising: (i) an extreme ultraviolet mirror; and (ii) a cavity overlaying at least a bottom part of the extreme ultraviolet mirror.

The extreme ultraviolet mirror will typically be on a substrate. The substrate may be any substrate but is typically a substrate suitable for use in manufacturing a mask for lithography. The substrate, may for example, be a quartz substrate. The extreme ultraviolet mirror may be any mirror suitable for reflecting extreme ultraviolet radiations. The EUV mirror may be a Bragg reflector comprising a multilayer stack of a first material alternating with a second material, wherein the first and second material have different refractive indices and wherein the thickness of the layers is such that the optical path length within each layer corresponds to a quarter of the wavelength of the incident light (e.g. 13.5 nm EUV light). For instance, it can be a stack of Si layers alternated with Mo layers. In typical embodiments, a capping layer will be present on the extreme ultraviolet mirror. The capping layer is most typically a Ru layer but can be any layer or multilayer suitable for protecting the extreme ultraviolet mirror from environmental attacks. Examples of such layer or multilayer are a Rh layer or a TiO₂/RuO₂ multilayer. The thickness of the capping layer is preferably chosen so that it does not reduce the reflectance at 13.5 nm wavelength by more than 3%. The thickness of the capping layer can be for instance from 2 to 3 nm e.g. 2.5 nm.

The assembly further comprises a cavity overlying at least a bottom part of the extreme ultraviolet mirror.

In a first set of embodiments, the cavity may be overlying part of the top surface of the EUV mirror. In this first set of embodiments, the cavity may expose part of the capping layer typically present on the EUV mirror or may expose part of the etch stop layer when such a layer is present above the EUV mirror and typically on the capping layer. The cavity may alternatively expose part of a seeding layer if such a layer is present on the capping layer. The seeding layer is a layer which promotes the selective formation of the EUV absorbing structure in the cavity. Typically, the seeding layer is a layer having the same chemical nature as the EUV absorbing structure. In this first set of embodiments, the cavity is typically formed by providing a dielectric mask layer over the EUV mirror followed by patterning the dielectric mask layer so as to form the cavity.

The cavity may be provided by providing a dielectric patterned template having a cavity, or dielectric mask features separated by a cavity, having a depth extending from an upper surface of the patterned template throughout its thickness.

In embodiments, the mask layer may be formed of SiO₂. The SiO₂ mask layer is preferably formed at a temperature below 250°C and more preferably below 180°C. Patterning the dielectric mask layer can be performed for instance by providing a spin-on-carbon (SoC) layer on the dielectric mask layer, providing a spin-on-glass layer (SoG) on the SoC layer, and forming a patterned photoresist on the SoG layer. The patterned photoresist should present an opening suitable for forming the cavity in the mask layer upon transfer therein. This transfer is typically obtained by etching through the SoG layer, the SoC layer and the mask layer and stopping at the capping layer.

In embodiments, the dielectric mask layer may be formed of SoC. Patterning the SoC mask layer can be performed for instance by providing a SoG layer on the SoC layer, and forming a patterned photoresist on the SoG layer. The patterned photoresist should present an opening suitable for forming the cavity in the mask layer upon transfer therein. This transfer is typically obtained by etching through the SoG layer and the SoC mask layer and stopping at the capping layer or on the etch stop layer if present.

In embodiments (not depicted in the figures), the cavity may be formed by providing a photoresist layer directly on the capping layer of the EUV mirror followed by patterning the photoresist layer so as to form the cavity in the photoresist. It is this cavity that will be at least partly filled in step b.

In a second set of embodiments, the cavity may extend in the extreme ultraviolet mirror and the bottom of the cavity may be lower than the top surface of the extreme ultraviolet mirror but higher than the bottom surface of the extreme ultraviolet mirror. To form such a cavity, an extreme ultraviolet mirror may be provided on a substrate, a capping layer may be provided on the extreme ultraviolet mirror, a dielectric layer (e.g. SiO₂ or Si₃N₄) may be provided on the capping layer, an SoC layer may be provided on the dielectric layer, an SoG layer may be provided on the SoC layer, and a patterned photoresist may be provided on the SoG layer. The patterned photoresist should present an opening suitable for forming the cavity in the EUV mirror layer upon transfer therein. This transfer is typically obtained by etching through the SoG layer, the SoC layer, the dielectric layer, the capping layer, and the EUV mirror layer and stopping before reaching the bottom of the EUV mirror layer. The exact depth at which the etching stops may be controlled for instance by placing an etch stop layer at that depth in the EUV mirror.

In both the first and the second set of embodiments, the cavity is overlaying at least a bottom part of the EUV mirror. In the first set of embodiments, the cavity is situated above the level of the top surface of the EUV mirror and typically the lateral extent of the cavity overlaps with part of the lateral extent of the top surface of the EUV mirror. In the second set of embodiments, the bottom of the cavity is situated above the level of the bottom surface of the EUV mirror but below the level of the top surface of the EUV mirror. Typically, the lateral extent of the cavity overlaps with part of the lateral extent of the bottom surface of the EUV mirror.

The cavity is defined by side walls and by a bottom surface. In embodiments, the side walls are formed of a dielectric material while in other embodiments, the sidewalls are formed of:
- EUV mirror material,
- Typically, capping material on the EUV mirror material,
- Typically, SAM material on the Capping material.

The surfaces forming the cavity are limited to the bottom of the cavity and its side walls. Each side walls preferably form an angle with the top surface on the EUV mirror of from 70° to 110°, preferably from 75° to 105°.

The width of the cavity may for instance be from 3 nm to 300 nm or from 8 nm to 100 nm.

The material of the mask layer is preferably non-crystalline. This is advantageous as it permits the sidewalls of the cavity to have a lower roughness. (This is further advantageous such that when absorber material is selectively deposited and later when the mask is removed, the absorber patterns do not suffer much from Line Edge Roughness and line Width Roughness.

The method of the first aspect further comprises a step b of at least partly filling the cavity with an EUV absorbing structure by forming the EUV absorbing structure selectively in the cavity. In other words, the EUV absorbing structure is formed selectively in the cavity with respect to any surface not forming part of the cavity.

By at least partly filling the cavity, it is meant that although the whole lateral extend of the cavity is filled, the cavity may either be filled completely or filled up to a certain height below the top of the cavity.

Filling the cavity is performed by electroless deposition (ELD) of the filling material.

In step b, the extreme ultraviolet absorbing structure is formed selectively in the cavity by electroless deposition.

As explained in the background, conventional Ta-based absorber materials, due to their relatively low extinction coefficient value k, require a relatively high thickness to be sufficiently absorbing. Such a high thickness leads to M3D effects which cannot be entirely mitigated by simply reducing that thickness. The use of alternative absorber materials having a higher extinction coefficient k than current Ta-based materials but possessing a similar refractive index n (e.g. between 0.86 and 1.02, preferably between 0.88 and 1.00 at 13.5 nm) permits to reduce the thickness of the EUV absorbing structure but typically requires a new formation method. As shown in the comparative example infra, finding a proper method permitting to make use of such materials was a challenge. The method of the first aspect meet that challenge.

ELD is used as it is very well suited to the selective deposition of metallic materials. The filling material preferably forms a layer of electrically conductive material in the cavity. The filling material preferably forms a layer of metallic material in the cavity. When the EUV absorbing structure is a multilayer, the bottom layer is preferably a conductive material and more preferably a metallic material. Conductive materials and metallic materials are preferred because they permit the filling step b to be by performed selectively by ELD. In particular, they permit selective deposition on a Ru cap layer by ELD. Metallic materials are particularly well suited for forming the EUV absorbing structure by the method of the present invention because they tend to have a high extinction coefficient k and they tend to be difficult to form by other methods.

The extreme ultraviolet absorbing structure may comprise a metallic material. In some embodiments, the extreme ultraviolet absorbing structure may consist of a metallic material.

The metallic material may for instance be a single metal, an alloy, or a doped metal or alloy.

Suitable metallic materials are selected from transition metals, post-transition metals, Sb and combination thereof.

Preferably, the EUV absorbing structure has an extinction coefficient k of at least 0.040, more preferably at least 0.050, even more preferably at least 0.060 and most preferably at least 0.065 at a wavelength of 13.5 nm. Such a high extinction coefficient k permits the thickness of the EUV absorbing structure to be at most 40 nm and preferably at most 35 nm while remaining sufficiently absorbing. For instance, the thickness of the EUV absorbing structure may be from 25 to 35 nm. This is much better than the prior art using TaBN for the EUV absorbing structure where this thickness must be at least 60 nm.

The EUV absorbing structure comprises a metallic material comprising an element selected from Ni, Co, Sb, In, Sn, and Ag.

In embodiments, the EUV absorbing structure may comprise a layer consisting of an element selected from Ni, Co, Sb, In, Sn, and Ag.

In embodiments, the EUV absorbing structure may comprise a layer consisting of an alloy of an element selected from Ni, Co, Sb, In, Sn, and Ag with one or more other element comprised in this list or not. Preferably, the resulting alloy has an extinction coefficient k of at least 0.040, more preferably at least 0.050, even more preferably at least 0.060 and most preferably at least 0.065 at a wavelength of 13.5 nm. For instance, the EUV absorbing structure may comprise a layer of NiPt. Preferably, at least 50 at% of the alloy is made of element selected from Ni, Co, Sb, In, Sn, and Ag.

In embodiments, the EUV absorbing structure may consist in a single layer of an element selected from Ni, Co, Sb, In, Sn, and Ag.

In embodiments, the EUV absorbing structure may consist of a single layer consisting of an alloy of an element selected from Ni, Co, Sb, In, Sn, and Ag with one or more other element comprised in this list or not. Preferably, the resulting alloy has an extinction coefficient k of at least 0.040, more preferably at least 0.050, even more preferably at least 0.060 and most preferably at least 0.065 at a wavelength of 13.5 nm. For instance, the EUV absorbing structure may comprise a layer of NiPt. Preferably, at least 50 at% of the alloy is made of element selected from Ni, Co, Sb, In, Sn, and Ag.

In embodiments, the extreme ultraviolet absorbing structure may comprise layers of extreme ultraviolet absorbing metallic material comprising an element selected from Ni, Co, Sb, In, Sn, and Ag (e.g. having an extinction coefficient k of at least 0.040, more preferably at least 0.050, even more preferably at least 0.060 and most preferably at least 0.065 at a wavelength of 13.5 nm) alternated with spacer layers.

In embodiments, the EUV absorbing structure may consist in a multilayer alternating layers of an element selected from Ni, Co, Sb, In, Sn, and Ag with spacer layers.

In embodiments, the EUV absorbing structure may consist in a multilayer alternating a) layers an alloy of an element selected from Ni, Co, Sb, In, Sn, and Ag with one or more other element comprised in this list or not, with b) spacer layers. Preferably, at least 50 at% of the alloy is made of element selected from Ni, Co, Sb, In, Sn, and Ag.

In any embodiments, the EUV absorbing structure may comprise one or more doped metal layers, e.g. metal layers doped with up to 20 at% B or P.

Preferably, the resulting alloy involved in the layer described as a) has an extinction coefficient k of at least 0.040, more preferably at least 0.050, even more preferably at least 0.060 and most preferably at least 0.065 at a wavelength of 13.5 nm. For instance, these layers of an alloy may be layers of NiPt.

The elements Ni, Co, Sb, In, Sn and Ag are advantageous as they have an extinction coefficient k of at least 0.065 at 13.5 nm and they can be selectively grown on the bottom of the cavity by ELD.

Preferably, the filling material consist of Ni, Co, Ag, CoWP, Ni(B) or NiPt. Ni(B) is Ni doped with up to 20at% of B. Most preferably, the filling material consists of Ni or Co. These two materials are metals and have the advantage that they can be grown by ELD. Sn is not preferred because its use is typically avoided in EUV scanners. The melting point of Sn is very low which is also a disadvantage. Sb is also preferably avoided in EUV scanners because it is toxic when forming volatile hydrogen compounds such as H₃Sb. Ag has interesting EUV properties but it has a higher tendency to crystallize than Co or Ni, leading to EUV absorbing structures having rough side walls, which is not preferred.

The spacer layers are made of a material different from Ni, Co, Sb, In, Sn, and Ag; and different from an alloy of an element selected from Ni, Co, Sb, In, Sn, and Ag with one or more other element comprised in this list or not. The spacer layers are preferably not metallic. The spacer layers are preferably made of an amorphous material. Examples of suitable spacer layers are TiN and MgO. Preferably, the spacer layers are selected in such a way that the side walls of the cavity can be removed without removing the spacer layers.

The method of the first aspect is performed at a temperature lower than 250°C, preferably lower than 180°C, more preferably lower than 150°C and yet more preferably not larger than 100°C. This has the advantage to impose a low thermal budget and hence a low consumption of energy. This also has the advantage to prevent damaging the EUV mirror.

In embodiments, the assembly provided in step a may further comprise:
- a self-assembled monolayer of a first type present in the cavity for promoting the selective formation of the extreme ultraviolet absorbing structure therein, and/or
- a self-assembled monolayer of a second type present on a surface not forming part of the cavity for preventing the formation of the extreme ultraviolet absorbing structure thereon.

In embodiments, the assembly may further comprise a capping layer on the extreme ultraviolet mirror and the cavity may expose part of the capping layer.

In embodiments, the assembly may further comprise a capping layer on the extreme ultraviolet mirror and an etch stop layer on the capping layer, wherein the cavity exposes part of the etch stop layer.

In embodiments, the cavity may extend in the extreme ultraviolet mirror and the extreme ultraviolet absorbing structure may be partly embedded in the extreme ultraviolet mirror so that its bottom surface is lower than the top surface of the extreme ultraviolet mirror and that its top surface is higher or at the same level as the top surface of the extreme ultraviolet mirror.

In embodiments, a seed layer may overlie the extreme ultraviolet mirror and the cavity may open on the seed layer.

In embodiments, the cavity may be formed by providing a mask layer over the extreme ultraviolet mirror followed by patterning the mask layer so as to form the cavity. In these embodiments, the method may further comprise a step c of removing the mask layer selectively with respect to:
(i) the extreme ultraviolet absorbing structure, and
(ii) the extreme ultraviolet mirror or the capping layer if present.

In embodiments, a thickness of the extreme ultraviolet absorbing structure may be 60 nm or below, preferably 50 nm or below, yet more preferably 35 nm or below.

Not forming part of the invention, but considered useful for understanding the invention resulting from the claimed method, herein is also described an extreme ultraviolet reticle obtainable by any embodiment of the method of the first aspect.
Not forming part of the invention, but considered useful for understanding the invention resulting from
the claimed method, herein is also described an extreme ultraviolet reticle, comprising:
- an extreme ultraviolet mirror (2); and
- a metallic extreme ultraviolet absorbing structure comprising an element selected from Ni, Co, Sb, Ag, In, and Sn.
Any feature of the extreme ultraviolet reticle described herein may be as correspondingly described for
the first aspect.

In particular, the metallic extreme ultraviolet absorbing structure may have straight side walls.

In particular, the metallic extreme ultraviolet absorbing structure may be formed of Ag, CoWP, Ni doped with B or NiPt; preferably of Ni or Co.

In particular, the metallic extreme ultraviolet absorbing structure may have side walls forming an angle with the top surface on the EUV mirror of from 70° to 110°, preferably from 75° to 105°.

Not forming part of the invention, but considered useful for understanding the invention resulting from the claimed method, herein is also described an intermediate structure in the making of an extreme ultraviolet reticle, the intermediate structure comprising
- an extreme ultraviolet mirror;
- a mask layer over the extreme ultraviolet mirror, the mask layer being patterned with a cavity extending from a top surface to a bottom surface of the mask layer; and
- an extreme ultraviolet absorbing structure filling at least partly the cavity, the extreme ultraviolet absorbing structure comprising an a metallic material comprising an element selected form Ni, Co, Sb, Ag, In and Sn.

In this aspect, since the extreme ultraviolet absorbing structure is embedded laterally within a patterned dielectric template, which covers the capping layer typically present on the multi-layer mirror, the capping layer and the mirror will be protected against any damage that might happen if this intermediate reticle structure needs to be transported somewhere else or to another process tool

### Example 1: Formation of a reticle including a patterning step into an SiO₂ core

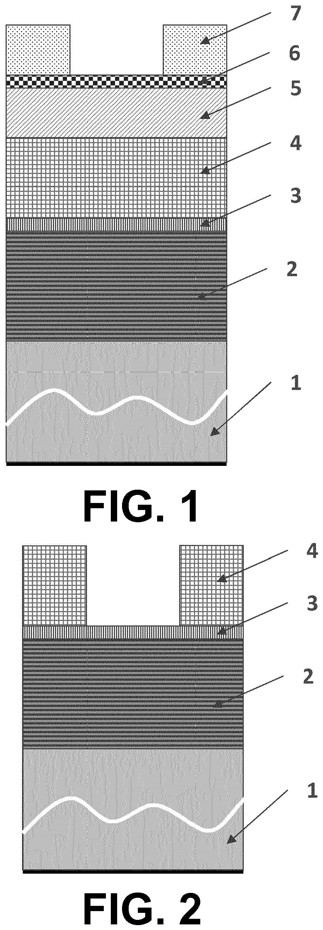

The purpose of this first example is to form a reticle by using SiO₂ as a template for the area selective deposition of Co or Ni (or compounds comprising Co or Ni). We now refer to FIG. 1. For this purpose, an assembly is provided comprising a multilayer EUV mirror (2) composed of alternating Si and Mo layers deposited on a substrate (1). A 2.5 nm Ru capping layer (3) is present on the multilayer EUV mirror (2). In order to provide a cavity over the EUV mirror, the following steps are performed at a temperature below 180°C. An SiO₂ layer (4) is provided on the Ru capping layer (3) by ALD. A SoC layer (5) is deposited on the SiO₂ layer (4) by spin-coating. A SoG layer (6) is deposited on the SoC layer (5) by spin-coating. A photoresist (7) is provided on the SoC layer (5). The photoresist (7) is patterned with an opening which lateral extend is such as to be suitable for providing the cavity in the SiO₂ layer (4) after transfer therein. In an alternative embodiment, the SoG (6) and SoC (5) layers may be replaced by an SiOC and an amorphous carbon (APF^{tm}) layer respectively. The SoG (6) and SoC (5) layers are however preferred because their use involves lower temperatures.

We now refer to FIG. 2. The pattern of the photoresist (7) is transferred into the SiO₂ layer (4) by a dry etching process. For this purpose, SoG (6) is opened with a fluorine-based plasma such as CF₄. Then, SoC (5) is opened with a N₂/H₂ plasma. The photoresist (7) is consumed during this last step. Then, SiO₂ (4) is etched with a C₄F₈/CHF₃/CF₄/O₂ plasma. The SoG (6) is consumed during this last step. This etching stops at the Ru capping layer (3) which serves as an etch stop layer. The remaining SoC (5) is then stripped with an O₂ plasma or a N₂H₂ plasma. In an alternative embodiment, the Ru capping layer has a Co layer or a Ni layer thereon to serve as a seeding layer for the formation of the EUV absorbing structure. In that embodiment, the etching of the SiO₂ (4) stops at that Co layer or Ni layer.

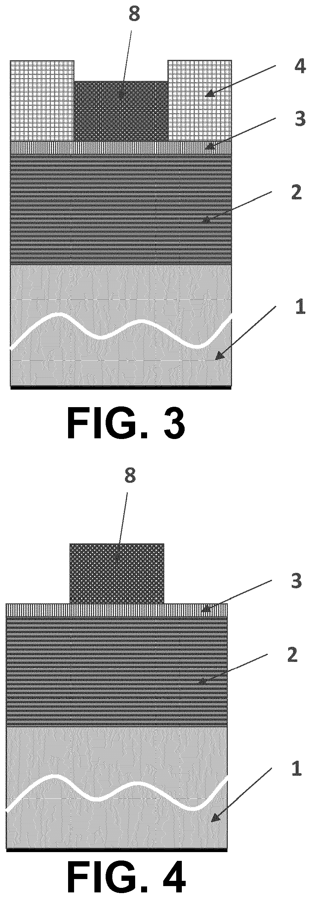

We now refer to Fig. 3. A 33 nm Co layer (8) is grown selectively in the cavity formed in the patterned SiO₂ layer (4) by ELD. In alternative embodiments, a Ni layer, a material comprising cobalt (e.g. CoWP) or a material comprising Ni (e.g. NiPt or Ni doped with B) can be grown instead of pure Co.

We now refer to Fig. 4. The patterned SiO2 layer is removed selectively with respect to the Ru capping layer and the deposited metal with diluted HF.

The obtained EUV absorbing structure being thin (33 nm), shadowing effects are low.

### Example 2: Formation of a reticle including a patterning step into an SoC core

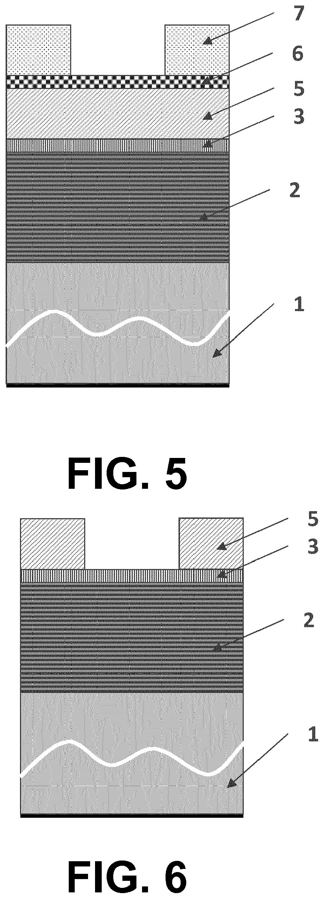

The purpose of this second example is to form a reticle by using an organic layer (a spin-on-carbon layer) as a template for the area selective deposition of Co or Ni or compounds comprising the same. We now refer to FIG. 5. For this purpose, an assembly is provided comprising a multilayer EUV mirror (2) composed of alternating Si and Mo layers deposited on a substrate (1). A 2.5 nm Ru capping layer (3) is present on the multilayer EUV mirror (2). In order to provide a cavity over the EUV mirror, the following steps are performed at a temperature below 180°C. A SoC layer (5) is provided on the Ru capping layer (3) by spin-coating. An SoG layer (6) is deposited on the SoC layer (5) by spin-coating. A photoresist (7) is provided on the SoG layer (6). The photoresist (7) is patterned with an opening which lateral extend is such as to be suitable for providing the cavity in the SoC layer (5) after transfer therein.

We now refer to FIG. 6. The pattern of the photoresist (7) is transferred into the SoG layer (6) by a dry etching process. For this purpose, SoG (6) is opened with a fluorine-based plasma such as CF₄. Then, SoC (5) is opened with a N₂/H₂ plasma. The photoresist (7) is consumed during this last step. This etching stops at the Ru capping layer (3) which serves as an etch stop layer. Remaining SoG (6) can be stripped with diluted HF which selectively etches SoG (6) with respect to SoC (5) and Ru (3).

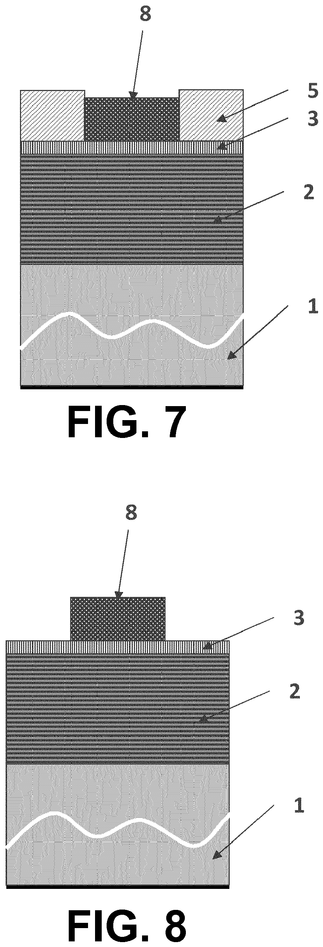

We now refer to Fig. 7. A 32 nm Ni layer (8) is grown selectively in the cavity formed in the patterned SoC layer (5) by ELD. In alternative embodiments, a Co layer, a material comprising cobalt (e.g. CoWP) or a material comprising Ni (e.g. NiPt or Ni doped with B) can be grown instead of pure Ni.

We now refer to Fig. 8. The patterned SoC layer (5) is removed selectively with respect to the Ru capping layer (3) and the deposited metal (8) with a O2 or N2/H2 plasma.

The obtained EUV absorbing structure being thin (32 nm), shadowing effects are low. The use of a SoC (5) for the side walls of the cavity has as advantage compared to SiO₂ (4) for the same purpose that an angle closer to 90° between the side walls and the mirror can be obtained.

### Example 3: Formation of a reticle including a cavity forming step into an SoC core with a SAM at the bottom of the cavity

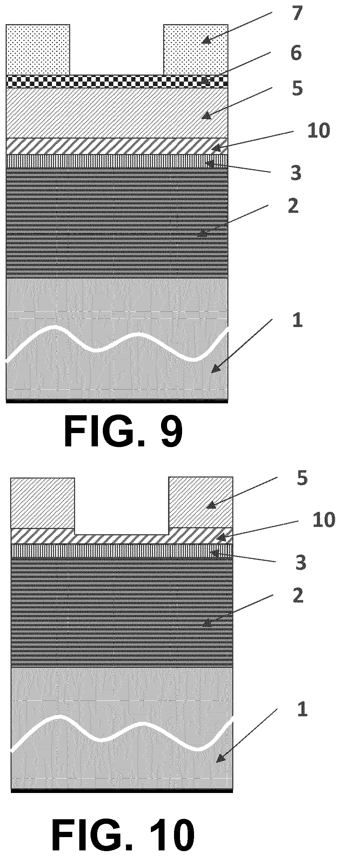

The purpose of this fourth example is to form a reticle by using an organic layer (5) (a spin-on-carbon layer) as a template for the area selective deposition of Co (8) or Ni (8) or compounds (8) comprising the same while introducing a SiO₂ or Si₃N₄ layer (10) as a protection layer on the Ru capping layer (3). An Si₃N₄ layer is preferred. We now refer to FIG. 9. For this purpose, an assembly is provided comprising a multilayer EUV mirror (2) composed of alternating Si and Mo layers deposited on a Si substrate (1). A 2.5 nm Ru capping layer (3) is present on the multilayer EUV mirror (2). An SiO₂ or Si₃N₄ layer (10) is deposited on the Ru capping layer (3) by a CVD process. In order to provide a cavity over the EUV mirror, the following steps are performed at a temperature below 180°C. A SoC layer (5) is provided on the An SiO₂ or Si₃N₄ layer (10) by spin-coating. An SoG layer (6) is deposited on the SoC layer (5) by spin-coating. A photoresist (7) is provided on the SoG layer (6). The photoresist (7) is patterned with an opening which lateral extend is such as to be suitable for providing the cavity in the SoC layer (5) and part of the SiO₂ or Si₃N₄ layer (10) after transfer therein.

We now refer to FIG. 10. The pattern of the photoresist (7) is transferred into the SoG layer (6) by a dry etching process. For this purpose, SoG (6) is opened with a fluorine-based plasma such as CF₄. Then, SoC (5) is opened with a N₂/H₂ plasma. The photoresist (7) is consumed during this last step. This etching is stoped at the SiO₂ or Si₃N₄ layer (10) which serves as an etch stop layer. Remaining SoG (6) can be stripped with diluted HF which selectively etches SoG (6) with respect to SoC (5) but etches part of the thickness of the SiO₂ or Si₃N₄ layer (10).

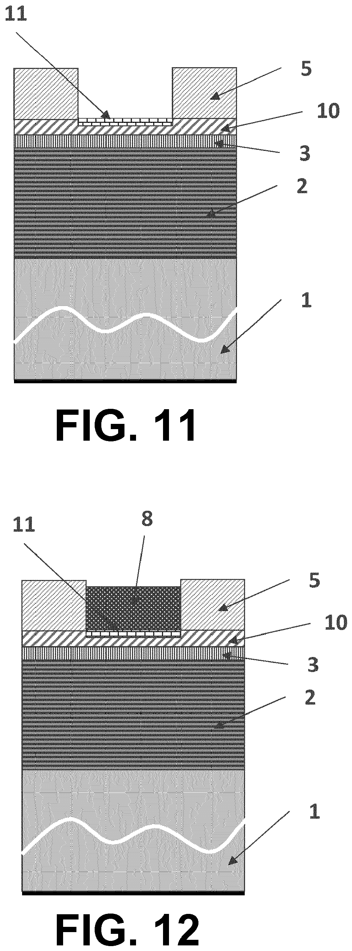

We now refer to Fig. 11. A SAM (11) is applied on the SiO₂ or Si₃N₄ layer (10) now accessible in the cavity. This SAM (11) comprises a reactive group for attaching selectively to the SiO₂ or Si₃N₄ layer (10). An example is a silane group. This SAM (11) further comprises a group promoting metal deposition and therefore imparting selective metal deposition with respect to the other surfaces of the reticle under construction. An example of such groups are thiol groups and polar groups. The presence of these thiol groups increases the selectivity of the metal (8) deposition. The SAM (11) preferably has a hydrophobic chain linking, on one hand, the reactive group for attaching selectively to the SiO₂ or Si₃N₄ layer, and on the other hand, the group promoting metal deposition. The hydrophobic chain may for instance be a hydrocarbyl comprising from 2 to 20 carbon atoms. The metal deposition can be performed by ELD via the use of a Pd catalyst and a metal precursor.

We now refer to Fig. 12. A 33 nm Co layer (8) is grown selectively in the cavity formed in the patterned SoC layer (5) by ELD. In alternative embodiments, a Ni layer, a material comprising cobalt (e.g. CoWP) or a material comprising Ni (e.g. NiPt or Ni doped with B) can be grown instead of pure Co.

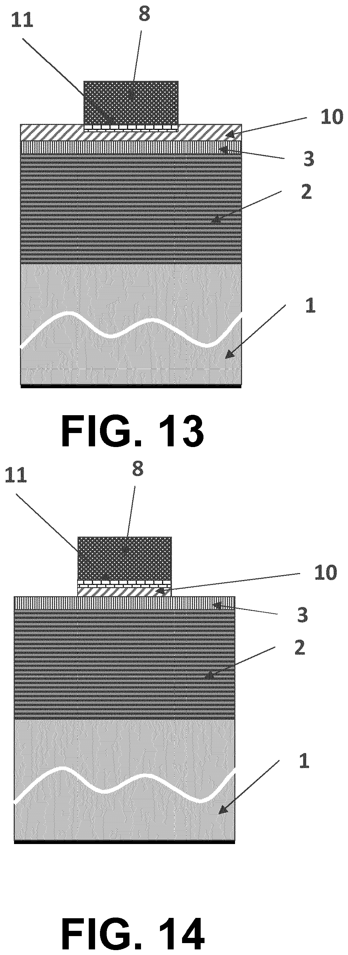

We now refer to Fig. 13. The patterned SoC layer (5) is removed selectively with respect to the SiO₂ or Si₃N₄ (10) and the deposited metal (8) with a O₂ or N₂/H₂ plasma.

We now refer to Fig. 14. The SiO₂ or Si₃N₄ (10) can be etched selectively with respect to the Ru (3) and the Co (8) by using the Co (8) as a mask. If Si₃N₄ (10) was used, this etching can for instance be performed by using a CHF₃/CF₄/O₂ plasma.

The obtained EUV absorbing structure being thin (33 nm), shadowing effects are low. The use of a SoC (5) for the side walls of the cavity has as advantage compared to SiO₂ (4) for the same purpose that an angle closer to 90° between the side walls and the mirror can be obtained.

### Example 4: Formation of a reticle comprising an embedded EUV absorbing structure

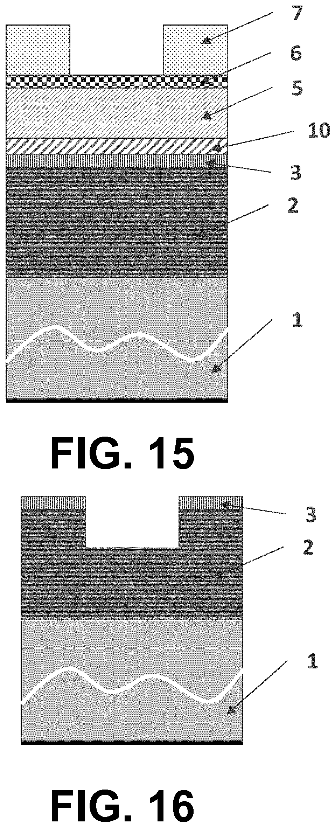

The purpose of this fifth example is to form a reticle by using the multilayer EUV mirror as a template for the area selective deposition of Co (8) or Ni (8) or compounds (8) comprising the same. We now refer to FIG. 15. For this purpose, an assembly is provided comprising a multilayer EUV mirror (2) composed of alternating Si and Mo layers deposited on a Si substrate (1). A 2.5 nm Ru capping layer (3) is present on the multilayer EUV mirror (2). An SiO₂ (or Si₃N₄ but SiO₂ is preferred) layer (10) is deposited on the Ru capping layer (3) by a CVD process. In order to provide a cavity in the EUV mirror (2), the following steps are performed at a temperature below 180°C. A SoC layer (5) is provided on the An SiO₂ layer (10) by spin-coating. An SoG layer (6) is deposited on the SoC layer (5) by spin-coating. A photoresist (7) is provided on the SoG layer (6). The photoresist (7) is patterned with an opening which lateral extend is such as to be suitable for providing the cavity in the EUV mirror (2) after transfer therein.

We now refer to FIG. 16. The pattern of the photoresist (7) is transferred into the SoG layer (6) by a dry etching process. For this purpose, SoG (6) is opened with a fluorine-based plasma such as CF₄. Then, SoC (5) is opened with a N₂/H₂ plasma. The photoresist (7) is consumed during this last step. This etching is stoped at the SiO₂ layer (10) which serves as an etch stop layer. The SiO₂ layer (10) is then opened with a CHF₃/CF₄/O₂/C₄F₈ plasma. The SoG layer (6) is consumed during this last step. The Ru capping layer (3) is etched with an O₂/Cl₂ plasma. The cavity is then transferred in the EUV mirror (2) by partially etching through it with a Cl₂ reactive ion etch or with a SF6/CH2F2/HE/N2 plasma.

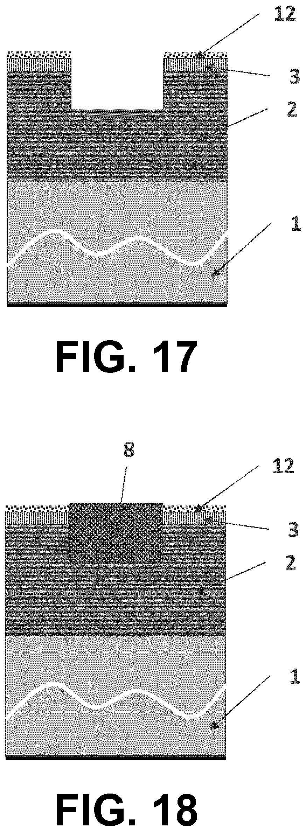

We now refer to FIG. 17. A SAM layer (12) is selectively applied on the Ru metal layer. A suitable SAM layer (12) is for instance a SAM layer (12) having of general formula R-SH having a thiol group for attaching to the Ru layer and a R group for preventing metal (8) deposition.

We now refer to FIG. 18. A 33 nm Co layer (8) is grown selectively in the cavity formed in the patterned EUV mirror by ELD. In alternative embodiments, a Ni layer, a material comprising cobalt (e.g. CoWP) or a material comprising Ni (e.g. NiPt or Ni doped with B) can be grown instead of pure Co.

### Example 5: Formation of a reticle comprising a multilayer EUV absorbing structure

The purpose of this sixth example is to form a reticle by using a SoC template for the area selective deposition of a multilayer EUV absorbing structure. We start after that the steps linked to FIG. 5 and 6 of example 2 have been performed.

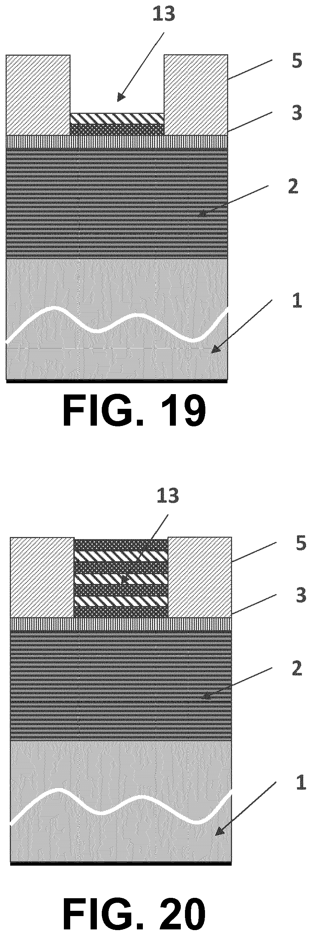

We now refer to Fig. 19. A Ni layer (8) is grown by ELD selectively in the cavity formed in the patterned SoC layer (5). A spacer layer (13) is then grown on the Ni layer (8) by ALD. Each layer (8, 13) is thinner than 6 nm. In alternative embodiments, a Co layer, a material comprising cobalt (e.g. CoWP) or a material comprising Ni (e.g. NiPt or Ni doped with B) can be grown instead of pure Ni. For the spacer layer, TiN or MgO can for instance be used. Preferably, after each deposition of a spacer layer (13), a treatment of the spacer layer (13) surface is preferably performed to allow the deposition of a further Ni layer (8) thereon.

We now refer to Fig. 20. Further Ni layers (8) and spacer layers (13) are grown alternatively until a thickness equal to 3.5 times a bilayer Ni layer (8) / spacer layer (13) is obtained. This alternation of metal (8) and spacer layers (13) is advantageous as it greatly reduces the tendency of the metal to crystalize. It also allows phase tuning. The thickness of the bilayer may be adapted to improve the focus shift.

### Example 6: prove of concept on a substrate without EUV mirror

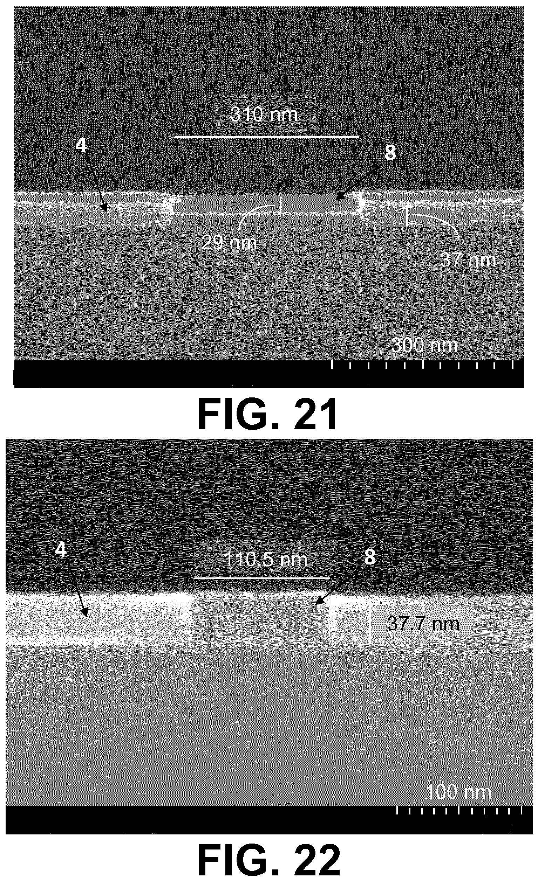

We now refer to Figs. 21. The purpose of this seventh example was to grow cobalt selectively in a cavity formed in SiO₂. For this purpose, a Si substrate (1) was provided. A 2.5 nm Ru capping layer (3) was present on the Si substrate (1). A 3 nm Co layer was provided on the Ru layer (3) by ELD. In order to provide a cavity over the EUV mirror, the following steps were performed at a temperature below 180°C. An SiOz layer (4) was provided on the 3nm Co layer by ALD. A SoC layer (5) was deposited on the SiO₂ layer (4) by spin-coating. A SoG layer (6) was deposited on the SoC layer (5) by spin-coating. A photoresist (7) was provided on the SoC layer (5). The photoresist (7) was patterned with openings which lateral extend was such as to be suitable for providing 310 nm wide trenches separated by 300 nm wide SiOz walls after transfer of the pattern in the SiO₂.

The pattern of the photoresist (7) was transferred into the SiO₂ layer (4) by a dry etching process. For this purpose, SoG (6) was opened with a CF4 plasma. Then, SoC (5) was opened with a N₂/H₂ plasma. The photoresist (7) was consumed during this last step. Then, SiO₂ (4) was etched with a C₄F₈/CHF₃/CF₄/O₂ plasma. The SoG (6) was consumed during this last step. This etching stopped at the 3 nm cobalt layer which served as an etch stop layer. The remaining SoC (5) was then stripped with an O₂ plasma or a N₂H₂ plasma.

The resulting openings in the SiO₂ were 310 nm wide and 37 nm deep.

A 29 nm Co layer (8) was grown selectively in the cavity formed in the patterned SiO₂ layer (4) by ELD.

We now refer to Figs. 22. The same example was repeated but the photoresist (7) was patterned with openings which lateral extend was such as to be suitable for providing 110.5 nm wide trenches separated by 200 nm wide SiO₂ walls after transfer of the pattern in the SiO₂. The resulting openings in the SiOz were 110.5 nm wide and 37.7 nm deep. These opening were completely filled with Co.

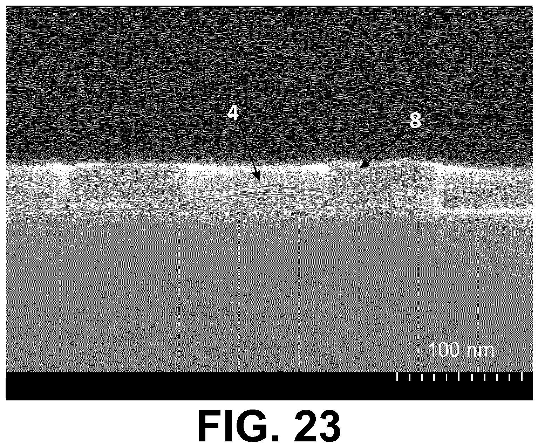

We now refer to Figs. 23. The same example was repeated but the photoresist (7) was patterned with openings which lateral extend was such as to be suitable for providing ~100 nm wide trenches separated by ~100 nm wide SiO₂ walls after transfer of the pattern in the SiO₂. The resulting openings in the SiOz were ~100 nm wide and ~ 40 nm deep. These opening were completely filled with Co.

### Comparative example on a substrate without EUV mirror

The purpose of this comparative example was to test if a reticle could be formed by directly etching the desired reticle EUV absorber pattern by subtracting material from a Ni layer present on a Ru layer on a substrate. For this purpose, an assembly was provided comprising a 2.5 nm Ru capping layer present on a Si substrate. A 25 nm Ni layer was then deposited on the Ru layer. A 5 nm Ru layer was deposited on the Ni layer to serve as an etch stop layer. A 100 nm TiN layer was deposited on the TiN to serve as a hard mask. A 50 nm SiO₂ layer was deposited on the TiN layer, a 130 nm SoC layer was deposited on the SiO2 layer, a 28 nm SoG layer was deposited on the SoC layer, and a photoresist was deposited and patterned on the SoG layer. This pattern was transferred to the hard mask in a conventional was by a series of etching steps. At this stage, two methods were tried to transfer the pattern in the Ni layer. The first method consisted in performing a physical reactive ion etch on the 5 nm Ru and the 25 nm Ni layer. The second method consisted in performing an ion beam etch on these same layers. In both cases, stopping at the bottom 2.5 nm Ru layer could not be achieved. Indeed, both these methods suffered from a lack of selectivity toward Ni with respect to Ru. Furthermore, both methods lead to inacceptable redeposition of sputter Ni residue on the 2.5 nm Ru, away from where Ni was desired. Also, the profile obtained for the Ni structure was difficult to control for both methods.

## Claims

1. A method for making an extreme ultraviolet reticle, comprising:
a. providing an assembly comprising:
(i) an extreme ultraviolet mirror (2); and
(ii) a cavity overlaying at least a bottom part of the extreme ultraviolet mirror (2);
b. at least partly filling the cavity, by filling the whole lateral extent of the cavity and filling the cavity either completely or up to a certain height below a top of the cavity, with an extreme ultraviolet absorbing structure (8) comprising a metallic material,
**characterized in that** the metallic material comprises an element selected from Ni, Co, Sb, Ag, In, and Sn, and that this element is selectively grown on the bottom of the cavity by electroless deposition.

2. The method according to claim 1, wherein the cavity overlaying at least a bottom part of the extreme ultraviolet mirror (2) is either:
• Comprised in a dielectric mask layer (4, 5) overlaying the extreme ultraviolet mirror (3), the cavity having a depth extending from a top surface of the dielectric mask layer (4, 5) to a bottom surface of the dielectric mask layer (4,5), or
• Comprised in the extreme ultraviolet mirror (2), the cavity having a depth extending from a top surface of the extreme ultraviolet mirror (2) to a level above the bottom surface of the extreme ultraviolet mirror (2).

3. The method according to claim 1, wherein the extreme ultraviolet absorbing structure (8) comprises layers of metallic extreme ultraviolet absorbing material (8) alternated with spacer layers (13).

4. The method according to any of the previous claims wherein the assembly provided in step a further comprises:
- a self-assembled monolayer (11) of a first type present in the cavity for promoting the selective formation of the extreme ultraviolet absorbing structure (8) therein, and/or
- a self-assembled monolayer (12) of a second type present on a surface not forming part of the cavity for preventing the formation of the extreme ultraviolet absorbing structure thereon.

5. The method according to any one of the preceding claims wherein the assembly further comprises a capping layer (3) on the extreme ultraviolet mirror (2) and wherein the cavity exposes part of the capping layer (3).

6. The method according to any one of claims 1 to 4 wherein the assembly further comprises a capping layer (3) on the extreme ultraviolet mirror (2) and an etch stop layer (10) on the capping layer (3), wherein the cavity exposes part of the etch stop layer (10).

7. The method according to any one of claims 1 to 4, wherein the cavity extends in the extreme ultraviolet mirror (2) and wherein the extreme ultraviolet absorbing structure (8) is partly embedded in the extreme ultraviolet mirror (2) so that the bottom surface of the extreme ultraviolet absorbing structure (8) is lower than the top surface of the extreme ultraviolet mirror (2) and that the top surface of the extreme ultraviolet absorbing structure (8) is higher or at the same level as the top surface of the extreme ultraviolet mirror (2).

8. The method according to any of the previous claims, wherein the cavity is formed by providing a dielectric mask layer (4, 5) over the extreme ultraviolet mirror followed by patterning the dielectric mask layer (4, 5) so as to form the cavity.

9. The method according to claim 8, further comprising a step c of removing the dielectric mask layer (4, 5) selectively with respect to:
(i) the extreme ultraviolet absorbing structure (8), and
(ii) the extreme ultraviolet mirror (2) or the capping layer (3) if present.

10. The method according to any of the previous claims, wherein a thickness of the extreme ultraviolet absorbing structure (8) is 60 nm or below, preferably 50 nm or below, yet more preferably 35 nm or below.

## Patentansprüche

1. Ein Verfahren zum Anfertigen eines extremen ultravioletten Retikels, umfassend:
a.- Bereitstellen einer Anordnung, umfassend:
(i)- einen extremen ultravioletten Spiegel (2); und
(ii)- einen Hohlraum, der mindestens einen unteren Teil des extremen ultravioletten Spiegel (2) überlagert;
b.- zumindest teilweise Füllen des Hohlraumes durch Füllen der gesamten seitlichen Ausdehnung des Hohlraumes und Füllen des Hohlraumes entweder vollständig oder bis zu einer bestimmten Höhe unter einer Oberseite des Hohlraumes, mit einer extremen ultravioletten absorbierenden Struktur (8), umfassend ein metallisches Material,
**dadurch gekennzeichnet, dass** das metallische Material ein Element umfasst, ausgewählt aus Ni, Co, Sb, Ag, In, und Sn, und dass dieses Element selektiv am Boden des Hohlraumes durch stromlose Abscheidung gezüchtet wird.

2. Das Verfahren nach Anspruch 1, wobei der Hohlraum, der mindestens einen unteren Teil des extremen ultravioletten Spiegels (2) überlagert entweder ist:
- in einer dielektrischen Maskenschicht (4, 5) enthalten, die den extremen ultravioletten Spiegel (3) überlagert, wobei der Hohlraum eine Tiefe aufweist, die sich von einer obersten Oberfläche der dielektrischen Maskenschicht (4, 5) zu einer unteren Oberfläche der dielektrischen Maskenschicht (4,5) erstreckt, oder
- in dem extremen ultravioletten Spiegel (2) enthalten ist, wobei der Hohlraum eine Tiefe aufweist, die sich von einer obersten Oberfläche des extremen ultravioletten Spiegels (2) auf eine Stufe über der unteren Oberfläche des extremen ultravioletten Spiegels (2) erstreckt.

3. Das Verfahren nach Anspruch 1, wobei die extreme ultraviolette absorbierende Struktur (8) Schichten aus metallischem extremem ultraviolettem absorbierendem Material (8) abwechselnd mit Abstandsschichten (13) umfasst.

4. Das Verfahren nach einem der vorstehenden Ansprüche, wobei die in Schritt a bereitgestellte Anordnung weiter umfasst:
- eine selbst zusammengestellte Einzelschicht (11) eines ersten Typs, die in dem Hohlraum zur Förderung der selektiven Bildung der extremen ultravioletten absorbierenden Struktur (8) darin vorhanden ist, und/oder
- eine selbst zusammengestellte Einzelschicht (12) eines zweiten Typs, die auf einer Oberfläche, die kein Bestandteil des Hohlraumes zum Verhindern der Bildung der extremen ultravioletten absorbierenden Struktur darauf vorhanden ist.

5. Das Verfahren nach einem der vorstehenden Ansprüche, wobei die Anordnung weiter eine Deckschicht (3) auf dem extremen ultravioletten Spiegel (2) umfasst, und wobei der Hohlraum einen Teil der Deckschicht (3) freilegt.

6. Das Verfahren nach einem der Ansprüche 1 bis 4, wobei die Anordnung weiter eine Deckschicht (3) auf dem extremen ultravioletten Spiegel (2) und eine Ätzstoppschicht (10) auf der Deckschicht (3) umfasst, und wobei der Hohlraum einen Teil der Ätzstoppschicht (10) freilegt.

7. Das Verfahren nach einem der Ansprüche 1 bis 4, wobei sich der Hohlraum in dem extremen ultravioletten Spiegel (2) erstreckt, und wobei die extreme ultraviolette absorbierende Struktur (8) teilweise in den extremen ultravioletten Spiegel (2) eingebettet ist, sodass die untere Oberfläche der extremen ultravioletten absorbierenden Struktur (8) niedriger als die oberste Oberfläche des extremen ultravioletten Spiegels (2) ist, und die oberste Oberfläche der extremen ultravioletten absorbierenden Struktur (8) höher oder auf derselben Stufe wie die oberste Oberfläche des extremen ultravioletten Spiegels (2) ist.

8. Das Verfahren nach einem der vorstehenden Ansprüche, wobei der Hohlraum durch Bereitstellen einer dielektrischen Maskenschicht (4, 5) über dem extremen ultravioletten Spiegel, gefolgt vom Mustern der dielektrischen Maskenschicht (4, 5) gebildet wird, um den Hohlraum zu bilden.

9. Das Verfahren nach Anspruch 8, weiter umfassend einen Schritt c umfasst, zum Entfernen der dielektrischen Maskenschicht (4, 5) selektiv in Bezug auf:
(i)- die extreme ultraviolette absorbierende Struktur (8), und
(ii)- den extremen ultravioletten Spiegel (2) oder die Deckschicht (3), falls vorhanden.

10. Das Verfahren nach einem der vorstehenden Ansprüche, wobei eine Dicke der extremen ultravioletten absorbierenden Struktur (8) 60 nm oder weniger, bevorzugt 50 nm oder weniger, noch bevorzugter 35 nm oder weniger beträgt.

## Revendications

1. - Un procédé pour fabriquer un réticule en ultraviolet extrême, comprenant :
a. la fourniture d'un ensemble comprenant :
(i) un miroir en ultraviolet extrême (2) ; et
(ii) une cavité recouvrant au moins une partie inférieure du miroir en ultraviolet extrême (2) ;
b. le remplissage au moins partiel de la cavité, en remplissant toute l'étendue latérale de la cavité et en remplissant la cavité soit complètement soit jusqu'à une certaine hauteur en dessous d'un sommet de la cavité, avec une structure absorbante en ultraviolet extrême (8) comprenant un matériau métallique,
**caractérisé en ce que** le matériau métallique comprend un élément sélectionné parmi Ni, Co, Sb, Ag, In et Sn, et que cet élément est cultivé sélectivement sur le fond de la cavité par dépôt autocatalytique.

2. - Le procédé selon la revendication 1, dans lequel la cavité recouvrant au moins une partie inférieure du miroir en ultraviolet extrême (2) est soit :
• Incluse dans une couche de masque diélectrique (4, 5) recouvrant le miroir en ultraviolet extrême (3), la cavité ayant une profondeur s'étendant d'une surface supérieure de la couche de masque diélectrique (4, 5) à une surface inférieure de la couche de masque diélectrique (4,5), ou
• Incluse dans le miroir en ultraviolet extrême (2), la cavité ayant une profondeur s'étendant d'une surface supérieure du miroir en ultraviolet extrême (2) à un niveau au-dessus de la surface inférieure du miroir en ultraviolet extrême (2).

3. - Le procédé selon la revendication 1, dans lequel la structure absorbante en ultraviolet extrême (8) comprend des couches de matériau absorbant en ultraviolet extrême métallique (8) alternées avec des couches d'espacement (13).

4. - Le procédé selon l'une quelconque des revendications précédentes dans lequel l'ensemble fourni à l'étape a comprend en outre :
- une monocouche auto-assemblée (11) d'un premier type présente dans la cavité pour promouvoir la formation sélective de la structure absorbante en ultraviolet extrême (8) à l'intérieur de celle-ci, et/ou
- une monocouche auto-assemblée (12) d'un second type présente sur une surface ne faisant pas partie de la cavité pour empêcher la formation de la structure absorbante en ultraviolet extrême sur celle-ci.

5. - Le procédé selon l'une quelconque des revendications précédentes dans lequel l'ensemble comprend en outre une couche de revêtement (3) sur le miroir en ultraviolet extrême (2) et dans lequel la cavité expose une partie de la couche de revêtement (3).

6. - Le procédé selon l'une quelconque des revendications 1 à 4 dans lequel l'ensemble comprend en outre une couche de revêtement (3) sur le miroir en ultraviolet extrême (2) et une couche d'arrêt de gravure (10) sur la couche de revêtement (3), dans lequel la cavité expose une partie de la couche d'arrêt de gravure (10) .

7. - Le procédé selon l'une quelconque des revendications 1 à 4, dans lequel la cavité s'étend dans le miroir en ultraviolet extrême (2) et dans lequel la structure absorbante en ultraviolet extrême (8) est partiellement intégrée dans le miroir en ultraviolet extrême (2) de sorte que la surface inférieure de la structure absorbante en ultraviolet extrême (8) est inférieure à la surface supérieure du miroir en ultraviolet extrême (2) et que la surface supérieure de la structure absorbante en ultraviolet extrême (8) est plus haute ou au même niveau que la surface supérieure du miroir en ultraviolet extrême (2).

8. - Le procédé selon l'une quelconque des revendications précédentes, dans lequel la cavité est formée en fournissant une couche de masque diélectrique (4, 5) sur le miroir en ultraviolet extrême suivie par la structuration de la couche de masque diélectrique (4, 5) de manière à former la cavité.

9. - Le procédé selon la revendication 8, comprenant en outre une étape c d'élimination sélective de la couche de masque diélectrique (4, 5) par rapport à :
(i) la structure absorbante en ultraviolet extrême (8), et
(ii) le miroir en ultraviolet extrême (2) ou la couche de revêtement (3) si présente.

10. - Le procédé selon l'une quelconque des revendications précédentes, dans lequel une épaisseur de la structure absorbante en ultraviolet extrême (8) est de 60 nm ou moins, de préférence de 50 nm ou moins, et encore plus préférablement de 35 nm ou moins.
